# EUROPÄISCHE PATENTSCHRIFT

(11) **EP 0 445 362 B1**
(45) Veröffentlichungstag und Bekanntmachung des Hinweises auf die Patenterteilung: **28.07.1993**
(21) Anmeldenummer: 90121276.1
(22) Anmeldetag: 07.11.1990
(51) Int. Cl.: G01R 33/032

(54) **Vorrichtung zum Messen einer magnetischen Induktion**
Magnetic induction measuring apparatus
Dispositif de mesure d'une induction magnétique

(30) Priorität: 09.03.1990 CH 773/90
(43) Veröffentlichungstag der Anmeldung: 11.09.1991
(73) Patentinhaber: Landis & Gyr Business Support AG, 6301 Zug (CH)
(72) Erfinder: Popoyic, Radivoje, Dr. Ing., CH-6300 Zug (CH); Hälg, Beat, Dr. Phys., CH-6330 Cham (CH); Seitz, Thomas, Dr. Sc. Techn., CH-6300 Zug (CH); Trächslin, Walter, Dr. Phys., CH-6318 Walchwil (CH)
(74) Vertreter: Müller, Hans-Jürgen, Dipl.-Ing.

(56) Entgegenhaltungen:
- EP-A- 0 081 412
- DE-A- 3 311 809
- PROCEEDINGS OF THE ANNUAL INTERNATIONAL CONFERENCE OF THE IEEE ENGINEERING IN MEDICINE AND BIOLOGY SOCIETY, New Orleans, Louisiana, 4. - 7. November 1988, Seiten 916-917; C.M. DAVIS et al.: "Interferometric fiber optic magnetometer"
- PATENT ABSTRACTS OF JAPAN, Band 8, Nr. 1 (P-246)[1438], 6. Januar 1984; & JP-A-58 165 071 (FURUKAWA DENKI KOGYO K.K.) 30-09-1983
- PATENT ABSTRACTS OF JAPAN, Band 9, Nr. 93 (P-351)[1816], 23. April 1985; & JP-A-59 218 971 (MATSUSHITA DENKI SANGYO K.K.) 10-12-1984

## Beschreibung

Die Erfindung bezieht sich auf eine Vorrichtung zum Messen einer magnetischen Induktion der im Oberbegriff des Anspruchs 1 genannten Art.

Solche Vorrichtungen eignen sich zur Messung der Frequenz, der Richtung und der Intensität eines Magnetfeldes, das beispielsweise durch einen elektrischen Strom erzeugt wird.

Eine Vorrichtung der im Oberbegriff des Anspruchs 1 genannten Art ist aus der DE-OS 34 09 207 A1 bekannt und umfasst einen Laser als Lichtquelle, dessen Licht in zwei Kanäle aufgeteilt wird. Jeder Kanal weist wenigstens einen Fabry-Perot-Resonator mit einem temperaturstabilisierten Wellenleiter und einem Lichtempfänger zum Messen der Transparenz des Resonators auf. Der Wellenleiter des ersten Resonators weist eine Hülle aus einem magnetostriktiven Material auf, so dass dessen optische Länge, bzw. dessen Transparenz, von der am Ort des Resonators herrschenden Induktion abhängig ist. Der Wellenleiter des im zweiten Kanal angeordneten optischen Resonators besteht aus einem transparenten piëzo-elektrischen Material. Die optische Länge dieses Resonators ist mittels eines elektrischen Feldes veränderbar, das von einer am Wellenleiter angelegten Abstimmspannung erzeugt ist. Ist die Transparenz in beiden Kanälen gleichgross, ist die Abstimmspannung ein Mass für die Induktion und in Einheiten der Induktion eichbar.

Der Erfindung liegt die Aufgabe zugrunde, eine einfache Vorrichtung der eingangs genannten Art zu schaffen, die einfach und kostengünstig herstellbar ist und sich miniaturisieren lässt.

Die genannte Aufgabe wird erfindungsgemäss durch die Merkmale des Anspruchs 1 gelöst. Weiterbildungen der Erfindung ergeben sich aus den Unteransprüchen.

Nachfolgend wird ein Ausführungsbeispiel der Erfindung anhand der Zeichnungen näher erläutert.

Es zeigt:
- Figur 1: eine Vorrichtung mit einem optischen Magnetfeldsensor,
- Figur 2: einen Wandler,
- Figur 3: die Messvorrichtung mit einem einzigen auslenkbaren Spiegel,
- Figur 4: den Magnetfeldsensor mit einem verschiebbaren Spiegel,
- Figur 5: den Magnetfeldsensor mit zwei verschiebbaren Spiegeln und
- Figur 6: eine Verwendung der Messanordnung.

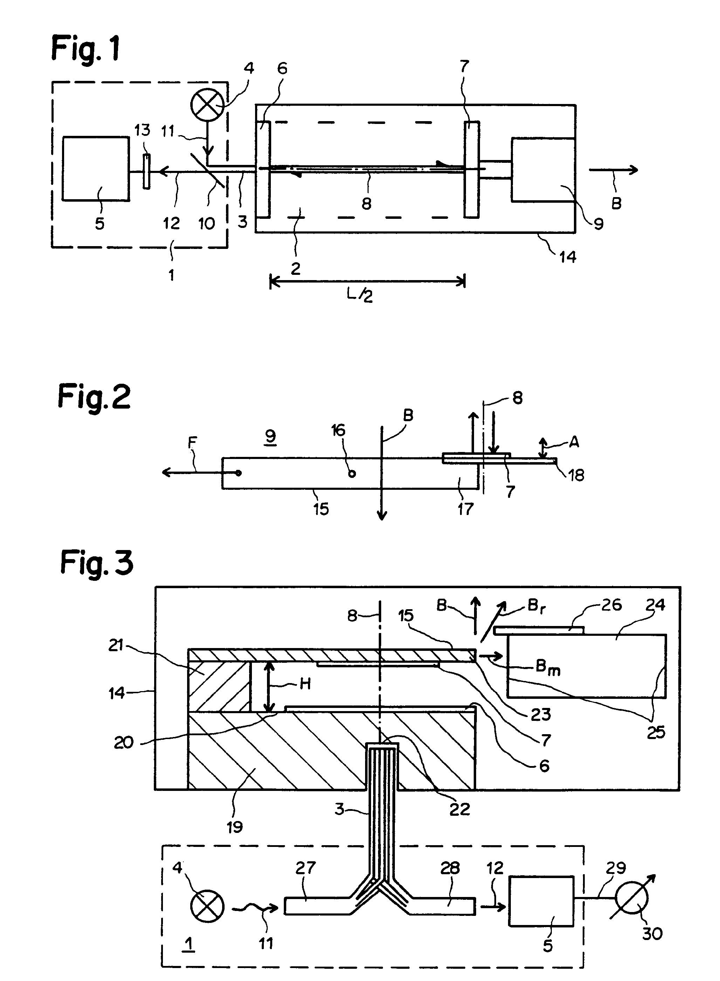

In der Figur 1 bedeutet 1 eine Auswerteeinrichtung, 2 einen optischen Resonator und 3 eine optische Uebertragungsstrecke, die die Auswerteeinrichtung 1 und den optischen Resonator 2 galvanisch getrennt verbindet. Die Auswerteeinrichtung 1 umfasst eine Lichtquelle 4, z. B. eine Weisslichtquelle, eine Leuchtdiode oder einen Laser, und einen einzigen Lichtempfänger 5, der das vom Resonator 2 veränderte Licht der Lichtquelle 4 analysiert und das Ergebnis z. B. in ein elektrisches Signal umsetzt.

Der optische Resonator 2 besteht aus zwei parallelen, einander in einem vorbestimmten Abstand gegenüberstehenden ebenen Spiegeln 6 und 7, die ein gasförmiges Medium zwischen sich einschliessen. Der Resonator 2 besitzt eine optische Achse 8, die gleichzeitig auf beiden Spiegeln 6 und 7 senkrecht steht. Der auf der optischen Achse 8 zwischen den beiden Spiegeln 6 und 7 gemessene Abstand entspricht der Hälfte der optischen Länge L des Resonators 2. Einer oder beide Spiegel 6, 7 sind längs der optischen Achse 8 mittels eines magnetischen Wandlers 9 verschiebbar. Der Wandler 9 setzt die wirksame Komponente der zu messenden Induktion, im folgenden Induktion B genannt, in einen vorbestimmten Weg längs der optischen Achse 8 um und verändert vorbestimmt die optische Länge L. Beispielhaft ist der zweite Spiegel 7 mechanisch mit dem magnetischen Wandler 9 verbunden.

Der Wandler 9 kann z. B. die bekannte Erscheinung der Magnetostriktion von Ferromagnetika oder die Differenz zwischen einer z. B. mechanischen Rückstellkraft und einer von der Induktion B auf einen Ferromagneten ausgeübten Kraft nutzen. Der Wandler 9 erzeugt Aenderungen der optischen Länge L im Bereich der Wellenlänge des zum Auslesen verwendeten Lichts.

Beispielsweise arbeitet der Resonator 2 in Reflexion, wobei der erste Spiegel 6 einen teildurchlässigen Belag aufweist, dessen Reflexionsvermögen für senkrecht auffallendes Licht zwischen 40 % und 75 % beträgt. Der zweite Spiegel 7 reflektiert hingegen mehr als 90 % des auffallenden Lichtes. Da der Abstand der Spiegel 6 und 7 gemessen auf der optischen Achse 8 gerade die Hälfte der optischen Länge L ist, wirkt sich der vom Wandler 9 erzeugte Weg des Spiegels 7 doppelt auf die optische Länge L aus.

In der Auswerteeinrichtung 1 ist ein Koppelglied 10 derart angeordnet, dass sowohl ein Lichtstrahl 11 aus der Lichtquelle 4 in die Uebertragungsstrecke 3 zum Resonator 2 gelangt als auch ein optischer Signalstrahl 12 aus dem Resonator 2 über die Uebertragungsstrecke 3 den Lichtempfänger 5 erreicht. Das Koppelglied 10 ist beispielsweise eine halbdurchlässige ebene Spiegelfläche, die unter einem Winkel von 45° zum Lichtstrahl 11 angeordnet ist und die den Lichtstrahl 11 in die Uebertragungsstrecke 3 lenkt.

Der Lichtstrahl 11 gelangt auf der optischen Achse 8 durch den teildurchlässigen ersten Spiegel 6 hindurch in den Resonator 2 und wird zwischen den beiden Spiegeln 6 und 7 hin und her geworfen. Ein vorbestimmter Anteil des Lichtes entkommt dem Resonator 2 wieder durch den teildurchlässigen ersten Spiegel 6 und erreicht zusammen mit einem vorbestimmten Anteil des am teildurchlässigen ersten Spiegel 6 direkt zurückgeworfenen Lichtstrahls 11 als Signalstrahl 12 den Lichtempfänger 5. Die beiden Komponenten des Signalstrahles 12 weisen für jede Wellenlänge eine von der optischen Länge L vorbestimmte Phasenverschiebung zueinander auf. Infolge der Interferenzeffekte ist die Intensität des Signalstrahls 12 wellenlängenabhängig moduliert. Damit die interferenzbedingte Modulation auftritt, muss die optische Länge L kleiner als die Kohärenzlänge des verwendeten Lichtes sein.

Sendet die Lichtquelle 4 weisses Licht aus, zerlegt vorzugsweise ein hier nicht gezeigtes Spektrometer im Lichtempfänger 5 den Signalstrahl 12 in ein Spektrum. Jede Veränderung der optischen Länge L ist im Spektrum als eine Verschiebung der Modulation der Intensität in bezug auf die Wellenlänge messbar.

Ist die Lichtquelle 4 schmalbandig oder ist ein Farbfilter 13 im Strahlengang des Lichtstrahles 11 bzw. des Signalstrahls 12 oder in der Uebertragungsstrecke 3 angeordnet, ist die Aenderung der optischen Länge L, wenn auch weniger genau, als Aenderung der Intensität des Signalstrahls 12 direkt mittels eines einfachen, hier nicht gezeigten Photometers in einer kostengünstigen Ausführung des Lichtempfängers 5 feststellbar. Vorzugsweise ist die optische Länge L auf die Wellenlänge des verwendeten Lichtes abstimmbar.

Da Licht für die Uebertragung an kein Medium gebunden ist, ist die Uebertragungsstrecke 3 allein durch den Lichtstrahl 11 und den Signalstrahl 12 festgelegt. Vorteilhaft werden jedoch wenigstens für die Uebertragungsstrecke 3 biegsame gebündelte Lichtleitfasern oder andere Lichtleiter verwendet, um teuere optische Einrichtungen zur Führung der Strahlen 11 und 12 zu vermeiden.

Das dem Resonator 2 zugewandten Ende des Lichtleiters der Uebertragungsstrecke 3 weist mit Vorteil eine als ersten Spiegel 6 ausgebildete Stirnfläche auf, um die Anzahl der Grenzflächen zu vermindern. Das Reflexionsvermögen für senkrecht auffallendes Licht der Stirnfläche kann auf bis auf 4 % reduziert werden, falls grosse Veränderungen der optischen Länge L von mehreren Wellenlängen des Lichts auftreten, die den Signalstrahl 12 genügend modulieren.

Ein geschlossenes Gehäuse 14 umschliesst vorteilhaft den Resonator 2 sowie den Wandler 9 und schützt den empfindlichen, optisch wirksamen Belag der Spiegel 6 und 7 vor Staub und aggressiven Gasen der Atmosphäre. Das Gehäuse 14 kann mit einer Schutzatmosphäre gefüllt sein, z. B. mit einem inerten Gas mit einem Druck von 1 Pa bis 1 MPa. Das Gehäuse 14 ist für die Induktion B durchlässig und weist wenigstens ein Fenster für den Lichtstrahl 11 und den Signalstrahl 12 auf. Das Gehäuse 14, das den Resonator 2 und den Wandler 9 als optischer Magnetfeldsensor enthält, bildet eine montagetechnisch vorteilhafte Baugruppe.

Die Messvorrichtung eignet sich mit Vorteil zum Messen der von einem elektrischen Strom verursachten Induktion B über die als galvanische Trennung wirkende Uebertragungsstrecke 3, da der Magnetfeldsensor nur einen gasgefüllten Resonator 2 aufweist, die Baugruppe des Magnetfeldsensors kostengünstig auf dem elektrischen Potential des Stromes montierbar ist und da sich in der Umgebung des Magnetfeldsensors verursachte elektrische Störungen weder auf den im Gehäuse 14 untergebrachten Wandler 9 noch über die Uebertragungstrecke 3 auf die elektrischen Signale des Lichtempfängers 5 auswirken. Ohne Einfluss auf die Messung ist die Länge der Uebertragungsstrecke 3 frei wählbar und den jeweiligen Einbaubedingungen anpassbar.

Der Wandler 9 weist in der Figur 2 vorteilhaft ein Element 15 aus einem ferromagnetischen Material auf. Das Element 15 ist in der Darstellung auf einer senkrecht zur Zeichenebene angeordneten Drehachse 16 drehbar gelagert und weist beispielhaft die Form eines länglichen zweiarmigen Hebels auf. Der eine Arm 17 trägt z. B. den zweiten Spiegel 7, so dass der zweite Spiegel 7 um die Drehachse 16 drehbar ist. Am anderen Arm greift eine vorbestimmte Rückstellkraft F an, um den zweiten Spiegel 7 in eine vorbestimmte Lage zu bringen, wenn der Betrag der Induktion B Null ist.

Auf das Element 15 wirken auf die Drehachse 16 bezogene mechanische Momente der Rückstellkraft F und der Induktion B ein, die das Element 15 um die Drehachse 16 drehen, bis sie sich im Gleichgewicht befinden und der zweite Spiegel 7 eine Auslenkung A in der Richtung der optischen Achse 8 aufweist.

Der durch die Induktion B verschiebbare Spiegel 6 (Figur 1) bzw. 7 ist vorteilhaft mit Dämpfungsflächen 18 verbunden, die in der Schutzatmosphäre eine Dämpfung der Bewegung des Spiegels 6 bzw. 7 bewirken, um ein Aufschaukeln von Schwingungen des Spiegels 6 bzw. 7 zu vermeiden. Das Mass der Dämpfung ist durch den Druck der Schutzatmosphäre und die Grösse der Dämpfungsflächen 18 vorbestimmt.

In der Figur 3 ist das Element 15 vorteilhaft als einseitig eingespannter einarmiger Hebel gestaltet, das sich durch geringe Trägheit auszeichnet. Im Gehäuse 14 ist ein ebenes, für das Licht transparentes Substrat 19 von vorbestimmter Dicke angeordnet. Ein Teil einer Oberfläche 20 des Substrates 19 ist als feststehender, teildurchlässiger erster Spiegel 6 ausgebildet. Unterhalb des Spiegels 6 weist die der Oberfläche 20 entgegengesetzte Seite des Substrats 19 eine zylindrische Vertiefung 22 auf, deren Achse mit der optischen Achse 8 zusammenfällt und die zum Ein- bzw. Auskoppeln der Strahlen 11 bzw. 12 dient.

In einer vorbestimmten Entfernung ausserhalb des ersten Spiegels 6 ist auf der Oberfläche 20 ein Distanzstück 21 von vorbestimmter Höhe H als Träger für das dünne, blattförmige ferromagnetische Element 15 angeordnet, dessen Fläche in seiner Ruhelage in der Höhe H parallel zur Oberfläche 20 ausgerichtet ist. Das Element 15 ist fest mit dem Distanzstück 21 verbunden und überragt freitragend auf einer Seite das Distanzstück 21, wobei das Element 15 mit seinem freien Ende 23 den ersten Spiegel 6 überdeckt. Unter dem Einfluss der Induktion B ist das freie Ende 23 in der optischen Achse 8 bewegbar und federt infolge der durch die Elastizität des Elementes 15 bewirkten Rückstellkraft F in seine Ruhelage zurück.

Dem ersten Spiegel 6 gegenüber ist die Fläche des Elements 15 als zweiter Spiegel 7 ausgebildet, so dass der Resonator 2 (Figur 1) die optische Länge L (Figur 1) von der zweifachen Höhe H aufweist. Sobald sich der Betrag der Induktion B vom Wert Null unterscheidet, erfährt das Element 15 eine Kraft in der Richtung der Induktion B und weist eine Auslenkung A (Figur 2) aus seiner Ruhelage in der Richtung der optischen Achse 8 auf.

Mit Vorteil ist das Element 15 mit seinem freien Ende 23 im Feld eines Magneten 24 mit den beiden Polflächen 25 angeordnet, damit die Auslenkung A im wesentlichen linear von der Induktion B abhängig ist. Beispielsweise ist ein Permanentmagnet 24 dem freien Ende 23 gegenüber auf dem Substrat 19 befestigt. Zwischen dem freien Ende 23 und wenigstens einer Polfläche 25 herrscht die Induktion Bm. Der Magnet 24 ist so auf das Element 15 ausgerichtet, dass das Element 15 unter der Wirkung der Induktion Bm seine vorbestimmte Ruhestellung aufweist. Das Element 15 zeigt mit dem freien Ende 23 immer in die Richtung der aus den beiden Induktionen B und Bm resultierenden Induktion Br. Die Auslenkung A ist für Bm >> B linear von B abhängig. Das Element 15 weist eine grössere Empfindlichkeit als ein freitragendes auf, weil es nicht mehr die volle Rückstellkraft F (Figur 2) aufbringen muss und daher eine geringere Trägheit aufweist.

Der Magnet 24 kann auch U-förmig gestaltet sein, wobei das Element 15 zwischen den beiden Polflächen 25 angeordnet ist.

Vorzugsweise ist der Magnet 24 zum Verändern der Richtung und des Betrages der Induktion Bm eingerichtet, z. B. mittels eines vorbestimmt einstellbaren Nebenschlusses 26, um den Resonator 2 auf einen vorbestimmten Wert der Induktion B, z. B. auf den Wert Null, abzugleichen.

Ein Lichtleiterbündel als Uebertragungsstrecke 3 steckt mit dem einen Ende in der Vertiefung 22 des Substrats 19 und bildet mit dem Substrat 19 einen guten optischen Kontakt, damit das Licht ohne störende Reflexionen vom Lichtleiterbündel zum Resonator 2 bzw. in umgekehrter Richtung übertreten kann. Kurz vor der Auswerteeinrichtung 1 teilen sich am anderen Ende des Lichtleiterbündels die Lichtleitfasern derart in zwei Aeste 27 und 28 auf, dass sich die Fasern der beiden Aeste 27 und 28 gleichmässig im ganzen Querschnitt des Bündels verteilen. Der erste Ast 27 nimmt den Lichtstrahl 11 von der Lichtquelle 4 auf und der zweite Ast 28 leitet den Signalstrahl 12 zum Lichtemfänger 5. Der Vorteil dieser Anordnung mit Lichtleiter besteht darin, dass das Koppelglied 10 (Figur 1) entfällt und ein genaues Ausrichten der Lichtquelle 4 und des Lichtempfängers 5 auf die Uebertragungsstrecke 3 nicht erforderlich ist.

Der Lichtempfänger 5 ist z. B. mittels einer Leitung 29 für das elektrische Signal mit einem Anzeigegerät 30 verbunden. Auf dem Anzeigegerät 30 ist der Betrag der Induktion B am Ort des Wandlers 9 (Figur 1) in einer entsprechenden Einheit ablesbar.

Beispielsweise besteht das Substrat 19 aus Glas oder aus einem Halbleiter, wie z. B. einkristallines Silizium. Diese Materialien ermöglichen eine kostengünstige Herstellung des Magnetfeldsensors in äusserst kleinen Abmessungen mit den bekannten Verfahren der Mikrotechnik. Solche Magnetfeldsensoren zeichnen sich nicht nur wegen ihrer Unempfindlichkeit gegen mechanischen Schock aus, sondern besitzen auch bis in den 10 kHz-Bereich ein gutes Frequenzverhalten zum Registrieren von schnellen Aenderungen der Induktion B.

Das freitragende Element 15 weist z. B. eine Länge von 1,5 mm, eine Breite von 1 mm und eine Dicke von 1 µm auf. Als ferromagnetisches Material ist z. B. Nickel oder die Legierung PERMALLOY™ verwendbar. Die die optische Länge L bestimmende Höhe H des Distanzstücks 21 beträgt bei der Verwendung von Weisslicht typisch einige Mikrometer bis einige 10 µm. Die Fasern des Lichtleiterbündels der Uebertragungsstrecke 3 weisen einen Durchmesser von etwa 50 µm auf.

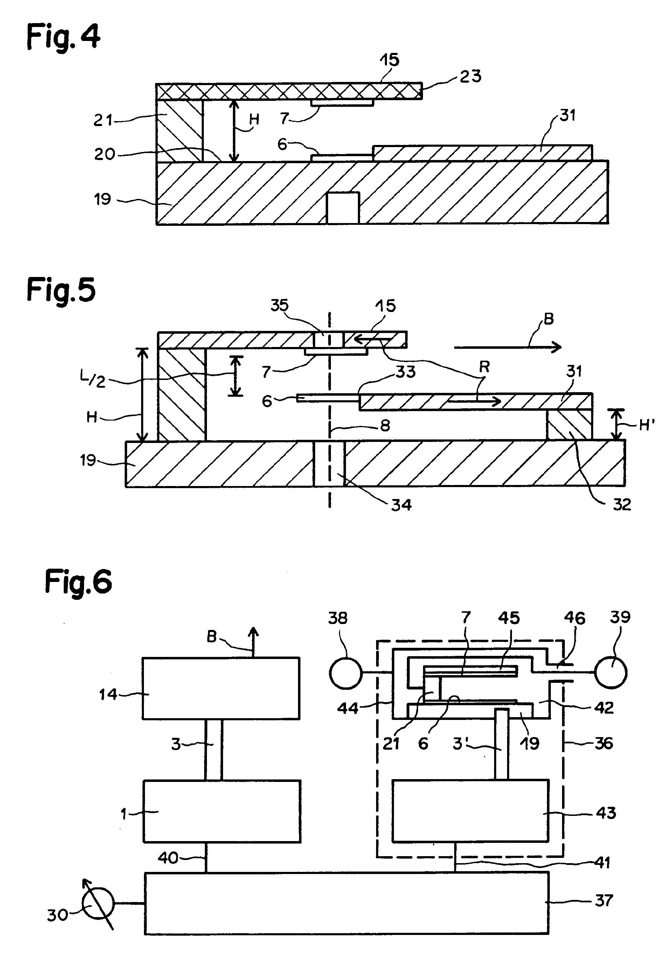

In der Figur 4 weist der Magnetfeldsensor auf der Oberfläche 20 des Substrates 19 vorteilhaft ein zusätzliches ferromagnetisches Formteil 31 auf, um die Richtungsempfindlichkeit des Mangetfeldsensors zu erhöhen. Das Formteil 31 ist unmittelbar neben dem ersten Spiegel 6 auf der Oberfläche 20 angeordnet, wobei das freie Ende 23 des Elements 15 einen Teil des Formteils 31 überlappt. Das Element 15 und das Formteil 31 sind vorzugsweise parallel zu einer gemeinsamen Geraden ausgerichtet. Ihr Abstand ist durch die Höhe H des Distanzstücks 21 vorbestimmt. Das Element 15 trägt den zweiten Spiegel 7, der zusammen mit dem gegenüberliegenden ersten Spiegel 6 den Resonator 2 (Figur 1) bildet.

Das Formteil 31 kann auch gemäss der Figur 5 mittels eines Stützers 32 in einem vorbestimmten Abstand H' über dem Substrat 19 angeordnet sein. Das Formteil 31 überragt den Stützer 32, so dass unter der Wirkung der Induktion B sein freitragender Endteil 33 bewegbar ist. Das Endteil 33 trägt den teildurchlässigen ersten Spiegel 6 und das Element 15 den zweiten Spiegel 7. Die beiden Spiegel 6 und 7 sind einander parallel gegenüber angeordnet und bewegbar. Die optische Länge L ist das Doppelte der Differenz der Höhen H und H'. Das Element 15 und das Formteil 31 weisen vorteilhaft einander entgegengesetzte remanente Induktionen R auf, um den Messbereich des Magnetfeldsensors zu vergrössern.

Mit Vorteil weist das auf dem Stützer 32 einseitig eingespannte Formteil 31 gleiche Eigenschaften wie das Element 15 auf, damit eine zusätzliche Biegung des Elementes 15 infolge einer äusseren mechanischen Beschleunigung mittels einer gleichen Biegung des Formteils 31 kompensiert wird, so dass sich die optische Länge L nicht ändert.

Die Uebertragungsstrecke 3 (Figur 1) führt durch eine auf die optische Achse 8 zentrierte Bohrung 34 im Substrat 19 zum Resonator 2 (Figur 1).

Das Element 15 und das Formteil 31 können auch parallel übereinander in vorbestimmten Abständen am gleichen Träger angeordnet sein.

Sind beide Spiegel 6 und 7 teildurchlässig und ist der Resonator 2 zwischen der Lichtquelle 4 (Figur 1) und dem Lichtempfänger 5 (Figur 1) angeordnet, ist die optische Länge L gerade das Dreifache der Distanz zwischen den Spiegeln 6 und 7. Der Resonator 2 verändert seine Transparenz entsprechend der durch die Induktion B veränderten optischen Länge L. Der Lichtstrahl 11 (Figur 1) tritt durch den ersten Spiegel 6 hindurch in den Resonator 2 ein. Der eine Teil des Lichtstrahls 11 durchdringt den Resonator 2 ohne Reflexion, verlässt den Resonator 2 zusammen mit dem anderen, wenigstens einmal an jedem der beiden Spiegeln 6 und 7 reflektierten Teil des Lichtstrahls 11 durch den zweiten Spiegel 7 und ein auf der optischen Achse 8 im Element 15 angeordnetes Loch 35 hindurch und bildet den von der optischen Länge L abhängigen modulierten Signalstrahl 12 (Figur 1).

Die Figur 6 zeigt eine vorteilhafte Kombination des oben beschriebenen Magnetfeldsensors mit einem Spannungsmessgerät 36 und einer Auswerteelektronik 37, die sich zum Messen von elektrischer Leistung oder von elektrischer Energie eignet. Für den im Gehäuse 14 untergebrachten Magnetfeldsensor ist keine galvanische Trennung zu einem stromführenden Leiter 38 notwendig, da die optische Uebertragungsstrecke 3 die galvanische Trennung bewirkt, die den Magnetfeldsensor mit der Auswerteeinrichtung 1 verbindet. Die Richtung des elektrischen Stromes im Leiter 38 ist der Induktion B entsprechend in die Zeichenebene hinein angenommen. Das Spannungsmessgerät 36 ist zwischen dem Leiter 38 und einem Leiter 39 eingeschaltet, der sich auf einem Bezugspotential befindet.

Die Auswerteelektronik 37 ist mittels eines elektrischen Pfads 40 für ein Stromsignal mit der Auswerteeinrichtung 1 und mittels einer Leitung 41 für ein Spannungssignal mit dem Spannungsmessgerät 36 verbunden. Die Auswerteelektronik 37 verarbeitet das Strom- und das Spannungssignal zu Leistungs- und Energiegrössen und zeigt sie auf dem Anzeigegerät 30 an.

Vorzugsweise umfasst das Spannungsmessgerät 36 einen elektrischen Feldsensor 42 und ein Auswertegerät 43, die mittels der zweiten Uebertragungsleitung 3' miteinander verbunden sind.

Der Feldsensor 42 ist beispielsweise mechanisch gleich wie der Magnetfeldsensor aufgebaut, nur dass sein Abschirmgehäuse 44 keine magnetischen Materialien enthält. Anstelle des Elementes 15 (Figur 3) ist ein in seinen Abmessungen gleiches Biegeelement 45 aus hochelastischem Siliziumdioxyd als Sensor für ein elektrisches Feld auf dem Distanzstück 21 angeordnet.

Die elektrisch leitenden Beläge der Spiegel 6 und 7 sind z. B. über das Distanzstück 21 elektrisch miteinander verbunden und stehen mittels einer isolierten Durchführung 46 des Abschirmgehäuses 44 mit dem Leiter 39 in Verbindung. Das Substrat 19 isoliert den Spiegel 6 gegen das Abschirmgehäuse 44, das auf dem Potential des Leiters 38 gehalten ist, so dass das Gehäuse 14 und das Abschirmgehäuse 44 das gleiche Potential aufweisen und daher mechanisch auf einfache Weise verbindbar sind. Wie bei einem Blattelektrometer verändert sich die optische Länge L (Figur 1) unter der Wirkung einer zwischen den Spiegeln 6 und 7 herrschenden elektrischen Abstosskraft.

In einer anderen Ausführung ist ein hier nicht gezeigter optischer Resonator mit einem Wellenleiter aus einem piëzoelektrischen Material als Feldsensor 42 eingesetzt. Die optische Länge L wird durch die an Elektroden angelegte Potentialdifferenz zwischen den Leitern 38 und 39 verändert.

Ist die Auswerteelektronik 37 auf dem Bezugspotential des Leiters 39, kann das Spannungssignal der Leitung 41 auch an einem hier nicht gezeigten Spannungssteiler bzw. Transformator abgegriffen werden, der zwischen den Leitern 38 und 39 angeordnet ist.

Die Auswertevorrichtung 1 wird vorzugsweise zur Abfrage beider Sensoren in den Gehäusen 14 und 44 eingesetzt, um ein aus dem Stromsignal und dem Spannungssignal bestehendes Signalpaar auf einfache Art zu gewinnen, wobei die Auswertevorrichtung 1 abwechslungsweise einen der beiden Sensoren optisch abfrägt und das jeweilige elektrische Signal erzeugt. Die Auswerteelektronik 37 speichert die gemessenen Werte eines Signalpaares, bevor die Leistung oder ein Energiequantum berechnet wird.

## Patentansprüche

1. Vorrichtung zum Messen einer Induktion (B) mittels eines optischen Resonators (2), der zwei parallele Spiegel (6; 7) aufweist und im Lichtweg zwischen einer Lichtquelle (4) und einem Lichtempfänger (5) angeordnet ist, wobei die Induktion (B) die optische Länge (L) des Resonators (2) verändert, dadurch gekennzeichnet, dass der einzige optische Resonator (2) mittels einer optischen Uebertragungsstrecke (3) mit einer Auswerteeinrichtung (1) verbunden ist, dass die Auswerteeinrichtung (1) die Lichtquelle (4) und den einzigen Lichtempfänger (5) umfasst, dass der Resonator (2) ein gasförmiges Medium zwischen den beiden Spiegeln (6; 7) aufweist und dass wenigstens einer der Spiegel (6 bzw. 7) an einen Wandler (9) zum Verschieben des Spiegels (6 bzw. 7) längs der optischen Achse (8) des Resonators (2) gekoppelt ist.

2. Vorrichtung nach Anspruch 1, dadurch gekennzeichnet, dass der Wandler (9) ein ferromagnetisches Element (15; 31) aufweist.

3. Vorrichtung nach Anspruch 2, dadurch gekennzeichnet, dass das ferromagnetische Element (15; 31) im Feld eines Magneten (24) angeordnet ist und dass die vom Magneten (24) erzeugte Induktion (Bm) grösser als die zu messende Induktion (B) ist.

4. Vorrichtung nach Anspruch 2 oder 3, dadurch gekennzeichnet, dass das Element (15) auf einem Distanzstück (21) einseitig fest eingespannt ist, dass sein freies Ende (23) mit dem zweiten Spiegel (7) verbunden ist und dass der erste Spiegel (6) teildurchlässig ist und auf einem Substrat (19) fest angeordnet ist.

5. Vorrichtung nach Anspruch 2 oder 3, dadurch gekennzeichnet, dass das Element (15) auf einem Distanzstück (21) einseitig fest eingespannt ist, dass sein freies Ende (23) mit dem zweiten Spiegel (7) verbunden ist, dass der erste Spiegel (6) teildurchlässig ist und auf einem freien Endteil (33) des einseitig auf einem Stützer (32) eingespannten Formteils (31) angeordnet ist und dass beide Spiegel (6; 7) vorbestimmt verschiebbar sind.

6. Vorrichtung nach Anspruch 5, dadurch gekennzeichnet, dass das Element (15) und das Formteil (31) Permanentmagnete sind, deren remanente Induktion (R) entgegengesetzt gerichtet sind.

7. Vorrichtung nach einem der Ansprüche 1 bis 6, dadurch gekennzeichnet, dass jeder durch die zu messende Induktion (B) bewegbare Spiegel (6; 7) Dämpfungsflächen (18) aufweist.

8. Vorrichtung nach einem der Ansprüche 1 bis 7, dadurch gekennzeichnet, dass der Resonator (2) und der Wandler (9) in einem geschlossenen Gehäuse (14) eingebaut sind.

9. Vorrichtung nach einem der Ansprüche 1 bis 8, dadurch gekennzeichnet, dass als Uebertragungsstrecke (3) zwischen dem Resonator (2) und der Lichtquelle (4) einerseits und dem Resonator (2) und dem Lichtempfänger (5) andererseits Lichtleiter vorhanden sind.

10. Vorrichtung nach Anspruch 9, dadurch gekennzeichnet, dass dem Resonator (2) zugewandten Stirnflächen des Lichtleiters der Uebertragungsstrecke (3) als teildurchlässiger erster Spiegel (6) des Resonators (2) ausgebildet sind.

11. Verwendung der Messvorrichtung nach einem der Ansprüche 1 bis 10 zur Messung von elektrischen Leistungs- oder Energiegrössen, dadurch gekennzeichnet, dass zusätzlich ein Spannungsmessgerät (36) und eine Auswerteelektronik (37) vorhanden sind, dass die Induktion (B) eines stromdurchflossenen Leiters (38) mittels der Messvorrichtung und die Spannung des Leiters (38) gegen ein Bezugspotential eines Leiters (39) mittels des Spannungsmessgeräts (36) messbar sind und dass die Auswerteelektronik (37) zum Auswerten eines Stromsignals der Messvorrichtung und eines Spannungssignals des Spannungsmessgeräts (36) eingerichtet ist.

## Claims

1. Apparatus for measuring an induction (B) by means of an optical resonator (2) which has two parallel mirrors (6; 7) and is arranged in the light path between a light source (4) and a light receiver (5), wherein the induction (B) varies the optical length (L) of the resonator (2), characterised in that the single optical resonator (2) is connected to an evaluation device (1) by means of an optical transmission section (3), that the evaluation device (1) includes the light source (4) and the single light receiver (5), that the resonator (2) has a gaseous medium between the two mirrors (6; 7) and that at least one of the mirrors (6 or 7) is coupled to a transducer (9) for displacement of the mirror (6 or 7) along the optical axis (8) of the resonator (2).

2. Apparatus according to claim 1 characterised in that the transducer (9) has a ferromagnetic element (15; 31).

3. Apparatus according to claim 2 characterised in that the ferromagnetic element (15; 31) is arranged in the field of a magnet (24) and that the induction (Bm) produced by the magnet (24) is greater than the induction (B) to be measured.

4. Apparatus according to claim 2 or claim 3 characterised in that the element (15) is fixedly clamped on a spacer portion (21) at one side, that its free end (23) is connected to the second mirror (7) and that the first mirror (6) is partially transmissive and is fixedly arranged on a substrate (19).

5. Apparatus according to claim 2 or claim 3 characterised in that the element (15) is fixedly clamped on a spacer portion (21) at one side, that its free end (23) is connected to the second mirror (7), that the first mirror (6) is partially transmissive and is arranged on a free end part (33) of the shaped portion (31) which is clamped on a support (32) at one side, and that both mirrors (6; 7) are predeterminedly displaceable.

6. Apparatus according to claim 5 characterised in that the element (15) and the shaped portion (31) are permanent magnets whose residual inductions (R) are oppositely directed.

7. Apparatus according to one of claims 1 to 6 characterised in that each mirror (6; 7) which is movable by the induction (B) to be measured has damping surfaces (18).

8. Apparatus according to one of claims 1 to 7 characterised in that the resonator (2) and the transducer (9) are installed in a closed housing (14).

9. Apparatus according to one of claims 1 to 8 characterised in that light guides are provided as the transmission section (3) between the resonator (2) and the light source (4) on the one hand and the resonator (2) and the light receiver (5) on the other hand.

10. Apparatus according to claim 9 characterised in that end faces of the light guide of the transmission section (3), which end faces are towards the resonator (2), are in the form of a partially transmissive first mirror (6) of the resonator (2).

11. Use of the measuring apparatus according to one of claims 1 to 10 for measuring electric power or energy paramaters, characterised in that there are additionally provided a voltage measuring device (36) and an electronic evaluation arrangement (37), that the induction (B) of a conductor (38) through which current flows can be measured by means of the measuring apparatus and the voltage of the conductor (38) relative to a reference potential of a conductor (39) can be measured by means of the voltage measuring device (36) and that the electronic evaluation arrangement (37) is adapted to evaluate a current signal of the measuring apparatus and a voltage signal of the voltage measuring device (36).

## Revendications

1. Dispositif de mesure d'une induction (B) au moyen d'un résonateur optique (2) qui comprend deux miroirs parallèles (6, 7) et qui est disposé sur la marche de la lumière entre une source lumineuse (4) et un récepteur de lumière (5), l'induction (B) faisant varier la longueur optique (L) du résonateur (2), caractérisé en ce que l'unique résonateur optique (2) est relié par une voie optique de transmission (3) à une dispositif d'analyse (1), en ce que le dispositif d'analyse (1) comprend la source lumineuse (4) et l'unique récepteur de lumière (5), en ce que le résonateur (2) comprend un fluide gazeux entre les deux miroirs (6 ; 7) et en ce qu'au moins l'un des miroirs (6 ou 7) est couplé à un convertisseur (9) destiné à provoquer le déplacement du miroir (6 ou 7) le long de l'axe optique (8) du résonateur (2).

2. Dispositif selon la revendication 1, caractérisé en ce que le convertisseur (9) comprend un élément ferromagnétique (15, 31).

3. Dispositif selon la revendication 2, caractérisé en ce que l'élément ferromagnétique (15, 31) est disposé dans le champ d'un aimant (24) et en ce que l'induction (Bm) produite par l'aimant (24) est supérieure à l'induction (B) à mesurer.

4. Dispositif selon la revendication 2 ou 3, caractérisé en ce que l'élément (15) est fixé d'un côté sur une entretoise (21), en ce que son extrémité libre (23) est reliée au second miroir (7) et en ce que le premier miroir (6) est semi-transparent et fixé sur un substrat (19).

5. Dispositif selon la revendication 2 ou 3, caractérisé en ce que l'élément (15) est fixé d'un côté sur une entretoise (21), en ce que son extrémité libre (23) est reliée au second miroir (7), en ce que le premier miroir (6) est semi-transparent et disposé sur une extrémité libre (33) de la pièce préformée (31) fixée d'un côté sur un support isolant (32) et en ce que les deux miroirs (6 ; 7) sont dépaçables de manière prédéterminée.

6. Dispositif selon la revendication 5, caractérisé en ce que l'élément (15) et la pièce préformée (31) sont des aimants permanents dont les inductions rémanentes (R) sont orientées en sens opposés.

7. Dispositif selon l'une des revendications 1 à 6, caractérisé en ce que chacun des miroirs (6 ; 7) mobiles sous l'effet de l'induction à mesurer (B) comporte des surfaces d'amortissement (18).

8. Dispositif selon l'une des revendications 1 à 7, caractérisé en ce que le résonateur (2) et le convertisseur (9) sont montés dans un boîtier fermé (14).

9. Dispositif selon l'une des revendications 1 à 8, caractérisé en ce que la voie de transmission (3) entre le résonateur (2) et la source lumineuse (4), d'une part, et le résonateur (2) et le récepteur de lumière (5), d'autre part, consiste en guides d'ondes lumineuses.

10. Dispositif selon la revendication 9, caractérisé en ce que la surface extrême du guide d'ondes lumineuses de la voie de transmission (3) qui est tournée vers le résonateur (2) est conformée en premier miroir semi-transparent (6) du résonateur (2).

11. Utilisation du dispositif de mesure selon l'une des revendications 1 à 10 pour la mesure de grandeurs électriques de puissance ou d'énergie, caractérisée en ce qu'un appareil de mesure de tension (36) et une électronique d'analyse (37) sont accessoirement prévus, en ce que l'induction (B) d'un conducteur (38) par lequel passe un courant est mesurable par le dispositif de mesure et la tension du conducteur (38) par rapport à un potentiel de référence d'un conducteur (39) est mesurable au moyen de l'appareil de mesure de tension (36) et en ce que l'électronique d'analyse (37) est conçue pour l'analyse d'un signal en courant du dispositif de mesure et d'un signal en tension de l'appareil de mesure de tension (36).
